(19) Europäisches Patentamt
European Patent Office
Office européen des brevets

(11) Numéro de publication: **0 229 563 B1**

# (12) FASCICULE DE BREVET EUROPEEN

(45) Date de publication du fascicule du brevet: **05.09.90**

(51) Int. Cl.[5]: **C08G 61/10**, C25B 3/10, H01B 1/12

(21) Numéro de dépôt: **86402802.2**

(22) Date de dépôt: **15.12.86**

(54) **Procédé de fabrication d'un film de polyparaphénylène et applications du film de polyparaphénylène obtenu.**

(30) Priorité: **17.12.85 FR 8518666**

(43) Date de publication de la demande: **22.07.87 Bulletin 87/30**

(45) Mention de la délivrance du brevet: **05.09.90 Bulletin 90/36**

(84) Etats contractants désignés: **DE GB**

(56) Documents cités:
**EP-A- 0 094 563**

**DIE MAKROMOLEKULARE CHEMIE, vol. 186, no. 12, décembre 1985, pages 2415-2425, Heidelberg, DE; J.-F. FAUVARQUE et al.: "Electrosynthesis of poly(1,4-phenylene) catalyzed by nickel complexes"**

(73) Titulaire: **ETAT FRANCAIS représenté par le Ministre des PTT (Centre National d'Etudes des Télécommunications), 38-40 rue du Général Leclerc, F-92131 Issy-les-Moulineaux(FR)**
Titulaire: **CENTRE NATIONAL DE LA RECHERCHE SCIENTIFIQUE (CNRS), 15, Quai Anatole France, F-75007 Paris(FR)**

(72) Inventeur: **Maurice, Francois, 125, Boulevard de la Corniche, F-22700 Perros-Guirec(FR)**
Inventeur: **Froyer, Gérard, Rue du Ruesquet, Breievenez, F-22300 Lannion(FR)**
Inventeur: **Pelous, Yvan, 22, Résidence Duroux, F-22300 Lannion(FR)**
Inventeur: **Petit, Michel, 81, avenue de la Division Leclerc, F-95160 Montmorency(FR)**
Inventeur: **Fauvarque, Jean-Francois, 6, rue Joseph Bara, F-75006 Paris(FR)**

(74) Mandataire: **Warcoin, Jacques et al, Cabinet Régimbeau 26, avenue Kléber, F-75116 Paris(FR)**

EP 0 229 563 B1

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

ACTORUM AG

## Description

La présente invention concerne un procédé de fabrication d'un film de polyparaphénylène, du type faisant appel à une réduction électrochimique, ainsi que les applications du film de polyparaphénylène obtenu par ledit procédé, à la réalisation de cellules photovoltaïques, de détecteurs-doseurs d'oxygène, de cellules électrochromes et de batteries.

Le polyparaphénylène sera désigné ci-après PPP.

Le PPP est un polymère semi-conducteur, de conductivité faible. Sa formule générale est $(C_6H_4)_x$, x étant le degré de polymérisation. Le PPP ne devient conducteur électrique qu'à condition d'être dopé par des accepteurs d'électrons (dopage P) ou des donneurs d'électrons (dopage N).

Dans les applications sus-mentionnées, le PPP, dopé ou non, sera utilisé avantageusement sous forme d'un film de très faible épaisseur. En particulier :

. l'application photovoltaïque nécessite des épaisseurs inférieures à $10^{-7}$ m pour minimiser la résistance,

. l'application électrochrome nécessite des épaisseurs inférieures au micron pour conserver une vitesse de commutation valable.

Or, aucune méthode de préparation du PPP, connue dans la technique antérieure, ne permet de l'obtenir sous forme de film mince bien caractérisé.

Ainsi, par exemple, les synthèses décrites par Kovacic et al. (P.Kovacic, A.Kyriakis, J.Am. Chem. Soc. 85, 454 (1963) ), ou par Fauvarque et al., (J.F. Fauvarque, M.A. Petit, F.Pfluger, A. Jutand, C. Chevrot, M. Troupel. Makromol Chem. Rapid Commun 4, 455 (1983) ), conduisent à la formation de poudres qui, étant insolubles et infusibles, ne sont pas filmogènes. On ne peut,par pastillage, obtenir des épaisseurs inférieures à 30 µm (problème de tenue mécanique). D'où la nécessité et l'intérêt de synthétiser le PPP directement sous forme de films minces.

D'autres auteurs proposent l'obtention de films par électrosynthèse par oxydation du benzène dans les conditions suivantes :

. oxydation du benzène ou du biphényle dans l'acétonitrile (T.Osa, A. Yildiz, T. Kurvana -J.A.C.S. 91 (14) (1969) 3994),

. oxydation du benzène dans $SO_2$ à - 20° C (M. Delamar, P.C. Lacaze, J.Y. Dumousseau, J.E. Dubois - Electrochimica acta 27-1 (1982) 61)

. oxydation du benzène à l'interface benzène-HF (A.F. Shepard, B.F. Dannels - J. polym. sci.A.1 4 (1966) 511 et I. Rubinstein - J. electrochem. soc. 130.7 (1983) 1506),

. oxydation du benzène dans le nitrobenzène (K. Kaeriyanma, M.A. Sato, K. Someno, S. Tanaka J. Chem. soc. chem. commun. (1984) 1199).

Mais ces quatre méthodes donnent des films qui ont les défauts suivants :

- preparation mal commode (dans $SO_2$ liquide ou HF), ou dans les conditions limites d'utilisation du solvant,
- enchaînement uniquement en para des motifs phénylènes non garanti,
- présence de OH, d'oxygène ou d'azote dans le film.

D'autres auteurs proposent, toujours dans le cas d'obtention de films par électrosynthèse, la réduction

de 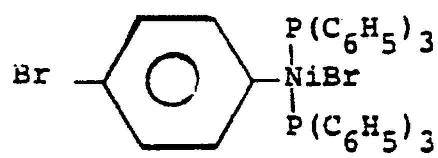

dans l'acétonitrile (G. Schiavon, G. Zotti, G. Bontempelli – J. electro. anal. chem. 161 (1984) 323).

Cette méthode donne un film avec des motifs phényl enchaînés en para, mais avec incorporation d'un nickel tous les 7 ou 8 cycles.

La présente invention concerne un procédé de fabrication d'un film de polyparaphénylène par électropolymérisation, du type faisant appel à une réduction électrochimique d'un monomère de formule:

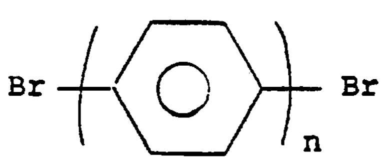

où n est un nombre entier compris entre 1 et 4, dans une cellule électrochimique comprenant une électrode de référence, une électrode de travail et une contre-électrode, baignées par un électrolyte comprenant un ou plusieurs solvants aprotiques dont l'un au moins est dipolaire, et un sel de fond anhydre, en

présence d'un catalyseur organométallique du type $NiX_2L$ où X est un halogène et L est un ligand, caractérisé en ce que l'électrode de travail est une cathode solide et en ce que le rapport molaire catalyseur/monomère est compris entre 0,1 et 1 et est notamment de l'ordre de 0,25.

Ainsi, pour synthétiser le PPP, il est fait appel à un procédé de type général connu dans l'art antérieur; il s'agit d'une réduction électrochimique d'un monomère de formule:

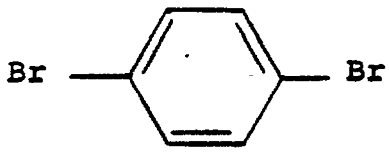

Cette réduction électrochimique correspond au schéma réactionnel suivant (n étant le degré de polymérisation) :

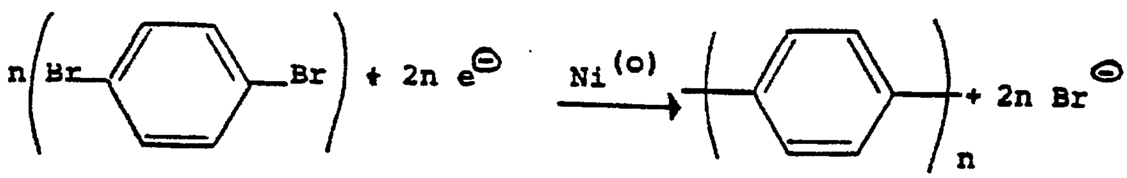

En ce qui concerne le catalyseur, des résultats récents ont montré que des complexes au nickel de valence O peuvent être générés in situ par réduction électrochimique de Ni $X_2$ L $_2$ avec X = Cl ou Br, L = $P(C_6H_5)_3$ ou $L_2 = (C_6H_5)_2\text{-}P\text{-}CH_2\text{-}CH_2\text{-}P\text{-}(C_6H_5)_2$

Ces complexes sont en conséquence immédiatement employés pour la synthèse de PPP par électroréduction de dibromobenzène.

L'électropolymérisation sus-mentionnée est effectuée sous atmosphère d'argon, à la température ambiante, dans une cellule à 3 électrodes, dont les compartiments anodique et cathodique sont séparés par un disque en verre fritté.

Les électrodes sont classiquement en mercure pour la cathode ou électrode de travail, en lithium pour l'anode, en argent pour l'électrode de référence.

Le principal inconvénient de cette méthode est que l'on obtient le PPP sous forme de poudre, inutilisable à bien des égards. En effet, dans de nombreux domaines et en particulier pour les applications du PPP mentionnées dans les exemples ci-après, il est nécessaire de recourir à un film de PPP, dont l'homogénéité et la finesse sont essentielles.

Les Demandeurs ont alors mis en évidence qu'une électrode de travail, ou cathode, composée d'une nappe de mercure, ne pouvait que mener à la synthèse de PPP sous forme de poudre. Ils ont aussi mis en évidence que l'utilisation d'une électrode de travail solide, en remplacement de l'électrode liquide de la technique antérieure, conduisait à la synthèse d'un film de PPP.

Ainsi, selon la présente invention, il est fait usage d'une cellule mono-compartimentée comprenant :

- une cathode solide, appartenant de préférence au groupe constitué par le graphite, le carbone vitreux, l'or, le nickel, le platine, le verre recouvert d'un oxyde conducteur du type $SnO_2$ ou oxyde d'indium et d'étain, (indium tin oxide ou ITO), le verre recouvert de métal;
- une anode ou contre-electrode qui est de préférence soluble, par exemple en lithium ou en magnésium, ou non soluble par exemple en or ou en platine ;
- une électrode de référence qui est, de préférence, en argent/perchlorate d'argent.

Ces trois électrodes, selon la présente invention, baignent dans un électrolyte comprenant un ou plusieurs solvants aprotiques. De préférence, l'électrolyte est constitué d'un mélange de deux solvants dans un rapport exprimé en volume de (2/3-1/3) pour le solvant aprotique et le solvant aprotique dipolaire respectivement. Ainsi, par exemple, l'électrolyte est un mélange de 2/3 de tétrahydrofuranne (THF) et de 1/3 d'hexaméthylphosphorotriamide (HMPT).

De préférence, selon la présente invention, on ajoute à l'électrolyte un sel de fond anhydre, d'une conductivité ionique certaine et ne fournissant pas de protons.

Il peut s'agir d'un sel choisi dans le groupe $LiClO_4$, $NaBF_4$, $NBu_4BF_4$.

Le monomère utilisé selon la présente invention répond à la formule

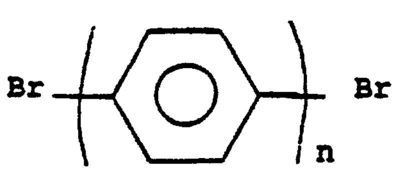

où n est un nombre entier compris entre 1 et 4. De préférence, n est egal à 1 ou 2, le 4,4' dibromobiphényl conduisant à des resultats particulièrement performants.

Les Demandeurs ont aussi mis en évidence que le rapport catalyseur/monomère doit être compris entre environ 0,1 et 1.

De préférence, ce rapport sera voisin de 0,25 pour l'obtention de films de PPP homogènes, conformes à l'invention.

Selon une caractéristique additionnelle de la présente invention, on soumet l'électrode de travail à une tension comprise entre-2,2 et-2,8 volts par rapport à l'électrode de référence $Ag/Ag^+$, de préférence à une tension de 2,5 volts.

Ainsi, selon un mode de mise en oeuvre préférentiel du procédé selon l'invention, on effectue la synthèse d'un film mince de PPP sur une plaque de verre recouverte d'oxyde conducteur ITO.

La figure 1 représente la cellule utilisée. Cette cellule monocompartimentée 1 comporte une cathode solide 2 réalisée sous la forme d'une plaque de verre recouverte d'oxyde conducteur ITO, une anode soluble en lithium 3 et dans un prolongement oblique 6 une électrode de référence 4 reliée par une rallonge séparatrice 5.

Les trois électrodes baignent dans un électrolyte dont le niveau supérieur est représenté en 7.

Au fond de la cellule, un barreau aimanté 8 permet l'homogénéisation du milieu.

La partie supérieure de la cellule est percée d'une ouverture 9 permettant le passage d'argon. Cette cellule est utilisée à l'air. Elle est étanche et un flux d'argon la ventile. Son volume utile est de 100 ml.

L'électrolyte comprend 70 ml de THF et 30 ml de HMPT. Ces deux solvants sont avantageusement préparés de la façon suivante :

. 70 ml de THF sont placés sur du naphtalène-sodium et distillés à pression atmosphérique sous balayage d'argon,

. 30 ml de HMPT sont placés sur $AlLiH_4$ et distillés sous vide primaire créé par une pompe à palettes.

Les életrodes utilisées sont les suivantes :

. l'électrode de référence 4 $Ag/Ag^+$ trempe dans une solution à 0,1 mole/litre de $Ag\ Cl\ O_4$ dans le THF ; elle est placée dans un prolongateur rempli d'électrolyte ;

. l'anode 3 en lithium consiste en un barreau métallique gratté au scalpel dans du THF et transféré à l'air dans la cellule de synthèse ;

. la cathode 2 consiste en une plaque de verre (de 13 x 37 mm) recouverte de $12 \times 10^{-8}$m d'oxyde conducteur ITO (50Ω/□), et recuite à 500°C. La face non conductrice est placée en face de l'anode en lithium.

Les réactifs utilisés sont les suivants :

. le monomère est du dibromobiphényle recristallisé, préparé par bromation du biphényl (1mMole),

. le catalyseur est du $NiCl_2L_2$ (0,25 mMole où $L_2 = (C_6H_5)_2\text{-}P\text{-}CH_2\text{-}CH_2\text{-}P\text{-}(C_6H_5)_2$,

. le sel de fond est du $LiClO_4$ séché sous vide à 160° C (0,03 Mole).

On utilise, au surplus, éventuellement, 110 mg de $Mg\ Br_2$ que l'on sèche avec $Li\ Cl\ O_4$.

Le sel de fond et le sel de magnésium sont d'abord mis à dissoudre dans le THF (agitation par un barreau magnétique). Le HMPT est rajouté après dissolution. Une part de cet électrolyte est alors versée dans le prolongateur de la référence.

Le monomère et le catalyseur sont introduits dans la cellule en dernier.

La polymérisation se fait en potentiostatique à - 2,5 volts par rapport à l'électrode de référence. Le courant moyen observé est de l'ordre de 0,5 mA. On arrête la synthèse après circulation d'une quantité de charge de 2 coulombs.

La plaque de verre recouverte d'oxyde conducteur est alors sortie de la cellule de synthèse et rincée dans un bain de THF.

Elle apparaît, après séchage à la soufflette, recouverte d'un film homogène semi-transparent de polyparaphénylène neutre et isolant (non dopé). Ce film est parfaitement stable à l'air, mince, homogène en épaisseur (jusque vers 1 μm d'épaisseur). Le polyparaphénylène est caractérisé comme tel par :

. l'absorption infrarouge donnant lieu à des bandes à 999 $cm^{-1}$, 1483 $cm^{-1}$, 805 $cm^{-1}$, (bande associée aux phényles disubstitués), 767 et 694 $cm^{-1}$ (bandes peu intenses associées aux phényles de bouts de chaînes) ;

. l'absorption U.V. montrant une bande large avec un maximum d'absorption vers 370 nm ;

. la diffraction X donnant lieu aux raies caracteristiques des réflexions (110), (200), (210) et (002) du PPP.

Le film de PPP obtenu est un semi-conducteur dont la conductivité faible est inférieure à $10^{-16}$ $\Omega^{-1}cm^{-1}$. Et c'est sous cette forme non dopée qu'il est utilisé pour la réalisation de cellules photovoltaïques (exp. 1) et de détecteurs doseurs d'oxygène ( exemple 2).

Par contre, pour réaliser des cellules électrochromes (exemple 3) et des batteries (exemple 4), il est nécessaire d'utiliser un film de PPP conducteur.

Pour ce faire, selon la présente invention, on effectue un dopage directement sur l'électrode de travail utilisée dans le procédé de fabrication.

Ainsi, partant du film de PPP préparé selon le mode de réalisation préférentiel de l'invention décrit cidessus, on peut réaliser un dopage électrochimique de type P de la façon suivante :

. la manipulation est de préférence réalisée en boîte à gants sous atmosphère d'argon "c" et en l'absence d'eau et d'oxygène,

. la cellule de dopage est de préférence un fond de tube à essai d'une contenance d'une dizaine de ml,

. le solvant est de préférence du carbonate de propylène qui a été distillé deux fois sous vide dans une colonne à bande tournante de téflon, et qui est maintenu sur tamis moléculaire 4 x $10^{-10}$ m.

On utilise un sel de fond tel que le $LiClO_4$ ou $LiBF_4$, séché sous vide à 150°C pendant plusieurs heures, et utilisé à la concentration de 1 mole/litre. Les électrodes sont de préférence les suivantes :

. la contre-électrode qui fait aussi office d'électrode de référence, est une bande de lithium de dimensions 0,38 x 5 x 10 mm (Alfa Products),

. l'électrode de travail est une électrode de verre recouverte d'ITO et de PPP comme indiqué ci-dessus.

Une fois le sel dissous et les deux électrodes installées, on maintient le potentiel du PPP à 3,5 V par rapport au couple $Li/Li^+$.

Si l'on effectue alors à intervalles réguliers des voltammogrammes entre 3,5 et 4,5 V, on observe une courbe I (V) c'est-à-dire donnant l'intensité du courant (en milli-ampère) en fonction de la différence de potentiel ou ddp (en volt) appliquée entre les deux électrodes. Cette courbe est du type de celle de la figure 2, avec des courants plus faibles mais croissant d'heure en heure.

Après 100 heures, le voltammogramme est celui de la figure 2 (pour une surface active de l'ordre de 1 $cm^2$). On explique cette croissance du phénomène par la nécessité d'attendre que l'électrolyte ait diffusé dans le film. En effet, comme celui-ci est isolant au départ, la réaction électrochimique doit démarrer à l'interface ITO-PPP où l'on doit donc aussi trouver l'électrolyte.

La réaction d'oxydation, qui se produit de façon significative au-delà de 4,1 volts, n'est pas complète à 4,5 volts. Elle s'explique classiquement par l'oxydation partielle des chaînes du polymère selon :

$$xy\ ClO_4^- + (C_6H_4)_x \rightarrow [(C_6H_4)^{y+},\ y\ ClO_4^-]_x + xy\ e^-$$

x est le degré de polymérisation
y est le taux de dopage.

Le polymère est électrochrome. Il absorbe la lumière dans l'état oxydé.

Le maximum d'absorption du polymère oxydé, observé à l'aide d'une cellule étanche placée dans une spectromètre visible, se situe vers 0,5 µm.

Si l'on excite la cellule avec des signaux carrés entre 3,5 et 4,5 V, on observe une réponse optique dont le temps de commutation typique est inférieur à 100 millisecondes.

EXEMPLE 1

APPLICATION DU FILM DE PPP A LA REALISATION DE CELLULES PHOTOVOLTAIQUES

La figure 3 représente les caractéristiques de l'intensité du courant I (ampères) en fonction de la différence de potentiel ddp (volts) d'une cellule photovoltaïque (Al/PPP (1µm)/ITO), dans le cadran où elle fournit de la puissance électrique.

Un sandwich métal/PPP/électrode conductrice, où le PPP est préparé par le procédé selon la présente invention se révèle posséder, en présence d'oxygène et sous illumination U.V., des caractéristiques de cellules photovoltaïques : une partie des photons absorbés crée des porteurs de charges qui, séparés par le champ électrique régnant dans une zone de charge d'espace interne au polymère, peuvent fournir de l'énergie à un circuit électrique extérieur.

Un film de PPP de 1 µm d'épaisseur (mesuré au microscope électronique à balayage )est déposé sur une plaque de verre recouverte d'ITO comme montré sur la figure 1.

De l'aluminium est évaporé sur le PPP (épaisseur 2 x $10^{-7}$m à travers un masque définissant des disques de 1 mm de diamètre.

On s'intéresse par la suite au composant constitué par : 1 disque de diamètre de 1 mm d'Al/PPP/ITO sur lequel on prend deux contacts (contact référencé "+" par laque d'argent sur ITO, "-" par contact pression sur l'aluminium).

Ce composant est alors illuminé à travers l'ITO par une lumière monochromatique centrée sur 429 nm (nanomètre), et de puissance 1 µW (micro Watt).

La caractéristique I (ddp) qui résulte de l'illumination est donnée par la Figure 3.

On constate que ce composant se comporte comme une cellule photovoltaïque capable de fournir de la puissance électrique : Sous un éclairement monochromatique (0,43 µm) de 0,127 $mW/cm^2$ :

Tension de circuit ouvert : 1,3 volt
Intensité de court circuit : 2,1 x $10^{-8}$ $A/cm^2$
Rendement : 5 x $10^{-5}$ ; vitesse de balayage : 1mV/sec.

Son comportement en fonction de la longueur d'onde incidente montre un maximum de réponse vers 426,5 nm avec une forte décroissance du photocourant dès que l'on s'écarte de cette valeur.

On peut ainsi réaliser des cellules photovoltaïques transparentes dans le visible.

EXEMPLE 2

APPLICATION DU FILM DE PPP A LA REALISATION DE DETECTEUR-DOSEUR D'OXYGENE

Les caractéristiques électriques des cellules photovoltaïques décrites dans l'exemple 1 évoluent sensiblement en fonction de la pression partielle d'oxygène dans le milieu environnant. L'état des caractéristiques électriques de la cellule est donc une sonde de la pression partielle en oxygène du milieu.

On utilise pour cette application la cellule photovoltaïque décrite dans l'exemple 1.

On fixe le potentiel à ses bornes à zéro volt et on mesure le courant de court-circuit (Icc) sous illumination à 0,43 µm. On fait passer sur le composant un flux d'azote auquel est mélangé une quantité variable d'oxygène (dosé avec un débitmètre à bille). On observe que le courant de court-circuit évolue réversiblement en fonction de la pression partielle d'oxygène dans le mélange (PPM).

| PPM volume $O_2$ | Icc x $10^{-11}$ A |
|---|---|
| 100 000 | 4,2 |
| 30 000 | 3,6 |
| 10 000 | 3,2 |
| 5 000 | 2,8 |

On démontre ainsi la possibilité d'utiliser une couche mince de polyparaphénylène pour doser les pressions partielles d'oxygène.

Cet effet peut également se rencontrer avec d'autres gaz oxydants.

EXEMPLE 3

APPLICATION DU FILM DE PPP DOPE A LA REALISATION DE CELLULES ELECTROCHROMES

Le PPP neutre est transparent dans le visible en film mince, alors que dopé P ou N il absorbe la lumière dans cette gamme de fréquences.

Le dopage électrochimique P ou N du PPP étant réversible dans certains solvants organiques, le PPP doit donc être considéré comme un électrochrome dans ces milieux: Transparent à un potentiel de 3 volts par rapport au couple $Li/Li^+$, il devient optiquement absorbant au-dessus de 4 volts (coloration rougeâtre) et en dessous de 1 volt par rapport à cette même référence. Le passage d'un état à l'autre se fait en un temps typique de 100 millisecondes.

Ce comportement électrochrome est observé lors du dopage électrochimique de type P du film de PPP obtenu par le procédé selon l'invention. Ce dopage se déroule conformément à la description qui en est faite ci-dessus. Ainsi, l'électrode, qui est quasiment transparente (un peu jaunâtre) à 3,5 volts lorsque le polymère est dédopé, devient d'un rouge sombre au potentiel de 4,5 volts correspondant à l'oxydation partielle des chaînes. On démontre un fonctionnement électrochrome réversible de cette cellule.

Ce changement de teinte a pu encore être observé sur une cellule que a effectué 30000 cycles (1 cycle = 1 seconde à 3,5 volts et 1 seconde à 4,5 volts).

EXEMPLE 4

APPLICATION DU PPP DOPE A LA REALISATION DE BATTERIE

Les cellules électrochromes précédemment décrites peuvent être utilisées comme batteries secondaires, car le dopage électrochimique N ou P s'accompagne de stockage réversible de charges négatives ou positives. L'électrode active étant un film mince, la capacité des batteries est faible, mais celles-ci peuvent être intégrées dans un composant mémoire, écran plat, etc. Ainsi, pour la réalisation d'une batterie à électrode active en couche mince, la cellule est celle utilisée lors du dopage. La Figure 2 montre que l'on peut réversiblement stocker et récupérer des charges dans l'électrode de polymère.

Avec une vitesse de balayage de 100 mV/sec., correspondant à un cycle charge-décharge effectué en 20 secondes, la quantité de charge mise en jeu est 0,8 x $10^{-3}$ coulomb/cm$^2$, la tension chutant à la décharge de 4,5 à 3,5 volts par rapport au couple $Li/Li^+$.

Si la vitesse de balayage est ramenée à 20 mv/sec., la quantité de charge stockée monte à 1,7 x $10^{-3}$ coulomb/cm$^2$. On montre donc la possibilité d'utiliser une couche mince de PPP déposée sur ITO comme électrode active d'une batterie secondaire. Le fait que l'ITO déposé sur verre est à la base de nouvelles

technologies (par exemple écrans plats), ouvre la perspective de batteries intégrées dans ce type de composant.

**Revendications**

1. Procédé de fabrication d'un film de polyparaphénylène par électro-polymérisation, du type faisant appel à une réduction électrochimique d'un monomère de formule:

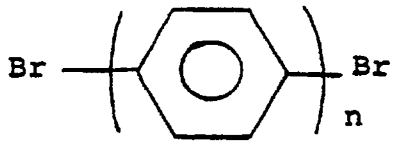

où n est un nombre entier compris entre 1 et 4, dans une cellule électrochimique comprenant une électrode de référence, une électrode de travail et une contre-électrode, baignées par un électrolyte comprenant un ou plusieurs solvants aprotiques dont l'un au moins est dipolaire, et un sel de fond anhydre, en présence d'un catalyseur organométallique de type $NiX_2L$ où X est un halogène et L est un ligand, caractérisé en ce que la réduction électrochimique du monomère est effectuée dans une cellule monocompartimentée, en ce que l'électrode de travail est une cathode solide et en ce que le rapport molaire catalyseur/monomère est compris entre 0,1 et 1, et est notamment de l'ordre de 0,25.

2. Procédé selon la revendication 1, caractérisé en ce que l'électrode de travail, ou cathode, est classée dans le groupe: graphite, carbone vitreux, or, nickel, platine, verre recouvert d'un oxyde conducteur du type $SnO_2$ ou oxyde d'indium et d'étain (indium tin oxide ou ITO), verre recouvert de métal.

3. Procédé selon l'une des revendications 1 à 2, caractérisé en ce que l'électrode de travail est en verre recouvert d'ITO.

4. Procédé selon l'une des revendications 1 à 3, caractérisé en ce qu'on soumet l'électrode de travail à une tension comprise entre –2,2 et –2,8 volts par rapport à l'électrode de référence.

5. Procédé selon l'une des revendications 1 à 4, caractérisé en ce que l'électrode de référence est une électrode argent/perchlorate d'argent.

6. Procédé selon l'une des revendications 1 à 5, caractérisé en ce que la contre-électrode est une anode soluble en lithium ou magnésium, ou non soluble en or ou platine.

7. Procédé selon l'une des revendications 1 à 6, caractérisé en ce que l'électrolyte est un mélange constitué par 2/3 de solvant aprotique, 1/3 de solvant dipolaire, tel que le mélange tétrahydrofurannehexaméthylphosphorotriamide (2/3 – 1/3, exprimé en volume).

8. Procédé selon l'une des revendications 1 à 7, caractérisé en ce que le sel de fond utilisé est choisi dans le groupe $LiClO_4$, $NaBF_4$ et $NBu_4BF_4$.

9. Procédé selon l'une des revendications 1 à 8, caractérisé en ce que le monomère utilisé a la formule suivante:

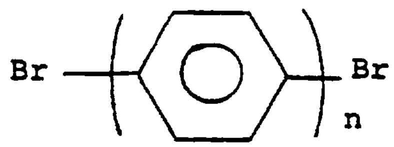

où n est égal à 1 ou 2.

10. Application du film de polyparaphénylène obtenu par le procédé selon l'une des revendications 1 à 9, à la réalisation de cellules photovoltaïques et de détecteurs-doseurs d'oxygène.

11. Application du film de polyparaphénylène obtenu par le procédé selon l'une des revendications 1 à 10, à la réalisation de cellules électrochromes et de batteries, caractérisée en ce que le polyparaphénylène est utilisé sous forme dopée, le dopage étant obtenu directement sur l'électrode de travail utilisée dans ledit procédé.

**Claims**

1. A method of manufacturing a polyparaphenylene film by electropolymerization, the method being of the type including electrochemical reduction of a monomer having the formula:

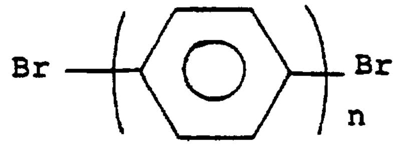

where n is an integer lying in the range 1 to 4, said electrochemical reduction taking place in an electrochemical cell comprising a reference electrode, a working electrode, and a counter electrode, all immersed in an electrolyte including one or more aprotic solvents, with at least one of said solvents being bipolar, and an anhydrous background salt in the presence of an organometallic catalyst of the $NiX_2L$ type where X is a halogen and L is a binder, characterized in that the monomer is electrochemically reduced in a one-compartment cell, and whereby the working electrode is a solid cathode and the ratio of catalyst to monomer lies in the range 0.1 to 1 and is in particular about 0.25.

2. A method according to claim 1, wherein the working electrode or cathode is taken from the group constituted by: graphite, vitreous carbon, gold, nickel, platinum, glass covered with a conductive oxide of the $SnO_2$ type or of the indium tin oxide (ITO) type, and metal-covered galss.

3. A method according to one of claims 1 and 2, wherein the working electrode is made of ITO-covered glass.

4. A method according to one of claims 1 to 3, wherein the working electrode is subjected to a voltage lying in the range –2.2 to –2.8 volts relative to the reference electrode.

5. A method according to one of claims 1 to 4, wherein the reference electrode is a silver/silver perchlorate electrode.

6. A method according to one of claims 1 to 5, wherein the counter electrode is a soluble lithium or magnesium anode or a non-soluble gold or platinum anode.

7. A method according to one of claims 1 to 6, wherein the electrolyte is a mixture of 2/3 by volume aprotic solvent and 1/3 by volume bipolar solvent, such as the mixture of tetrahydrofuranhexamethylphosphorotriamide (2/3 – 1/3, by volume).

8. A method according to one of claims 1 to 7, wherein the background salt used is selected from the group $LiClO_4$, $NaBF_4$ and $NBu_4BF_4$.

9. A method according to one of claims 1 to 8, wherein the monomer used has the following formula:

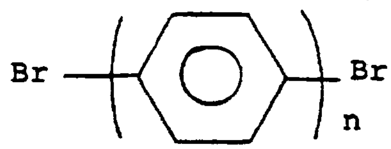

where n is equal to 1 or 2.

10. Application of the polyparaphenylene film obtained by the method according to one of claims 1 to 9 to implementing photovoltaic cells and oxygen detectors/meters.

11. Application of the polyparaphenylene film obtained by the method according to one of claims 1 to 10 to implementing electrochromic cells and batteries, wherein the polyparaphenylene is used in doped form, with the doping being obtained directly on the working electrode as used in said method.

**Patentansprüche**

1. Verfahren zur Herstellung von Filmen aus Polyparaphenylen durch Elektropolymerisation über eine elektrochemische Reduktion eines Monomeren der Formel

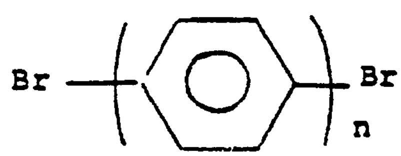 ,

worin n 1 bis 4 ist in einer elektrochemischen Zelle enthaltend eine Bezugselektrode, eine Arbeitselektrode und eine Gegenelektrode, wobei der Elektrolyt ein oder mehrere aprotische(s) Lösungsmittel – zumindest eines davon ist bipolar – und ein wasserfreies Grundsalz enthält, in Gegenwart eines Organometall-Katalysators $NiX_2L$, wobei X Halogen und L ein Ligand ist, dadurch gekennzeichnet, daß die elektrochemische Reduktion des Monomeren in einer Einkammer-Zelle durchgeführt wird, die Arbeitselektrode eine massive Kathode ist und das Mol-Verhältnis Katalysator:Monomer 0,1 bis 1 beträgt, insbesondere in der Größenordnung von 0,25, ist.

2. Verfahren nach Anspruch 1, dadurch gekennzeichnet, daß die Arbeitselektrode oder Kathode aus Graphit, glasigem Kohlenstoff oder Nickel, Platin, mit einem leitenden Oxid wie $SnO_2$ oder Indium- und Zinnoxid (Indiumzinnoxid) überzogenem Glas oder mit Glas überzogenem Metall besteht.

3. Verfahren nach einem der Ansprüche 1 oder 2, dadurch gekennzeichnet, daß die Arbeitselektrode mit Indiumzinnoxid überzogenes Glas ist.

4. Verfahren nach einem der Ansprüche 1 bis 3, dadurch gekennzeichnet, daß man an die Arbeitselektrode eine Spannung zwischen –2,2 und –2,8 Volt gegen die Bezugselektrode anlegt.

5. Verfahren nach einem der Ansprüche 1 bis 4, dadurch gekennzeichnet, daß die Bezugselektrode eine Silber/Silberperchlorat-Elektrode ist.

6. Verfahren nach einem der Ansprüche 1 bis 5, dadurch gekennzeichnet, daß die Gegenelektrode eine lösliche Anode aus Lithium oder Magnesium und/oder eine unlösliche Anode aus Platin ist.

7. Verfahren nach einem der Ansprüche 1 bis 6, dadurch gekennzeichnet, daß der Elektrolyt ein Gemisch von 2/3 aprotischem Lösungsmittel und 1/3 dipolarem Lösungsmittel besteht (Vol-Verhältnis) wie einem Gemisch von Tetrahydrofuran und Hexamethylphosphortriamid.

8. Verfahren nach einem der Ansprüche 1 bis 7, dadurch gekennzeichnet, daß das Grundsalz $LiClO_4$, $NaBF_4$ und/oder $NBu_4BF_4$ ist.

9. Verfahren nach einem der Ansprüche 1 bis 8, dadurch gekennzeichnet, daß das Monomere der Formel

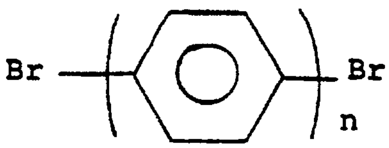

entspricht, worin n 1 oder 2 ist.

10. Anwendung des nach einem der Ansprüche 1 bis 9 erhaltenen Polyparaphenylenfilms in photovoltaischen Zellen und in Sauerstoff-Fühlern.

11. Anwendung des nach den Ansprüchen 1 bis 10 erhaltenen Polyparaphenylenfilms in elektrochromen Zellen und Batterien, dadurch gekennzeichnet, daß dotiertes Polyparaphenylen verwendet wird, wobei die Dotierung direkt auf der Arbeitselektrode erhalten worden ist.

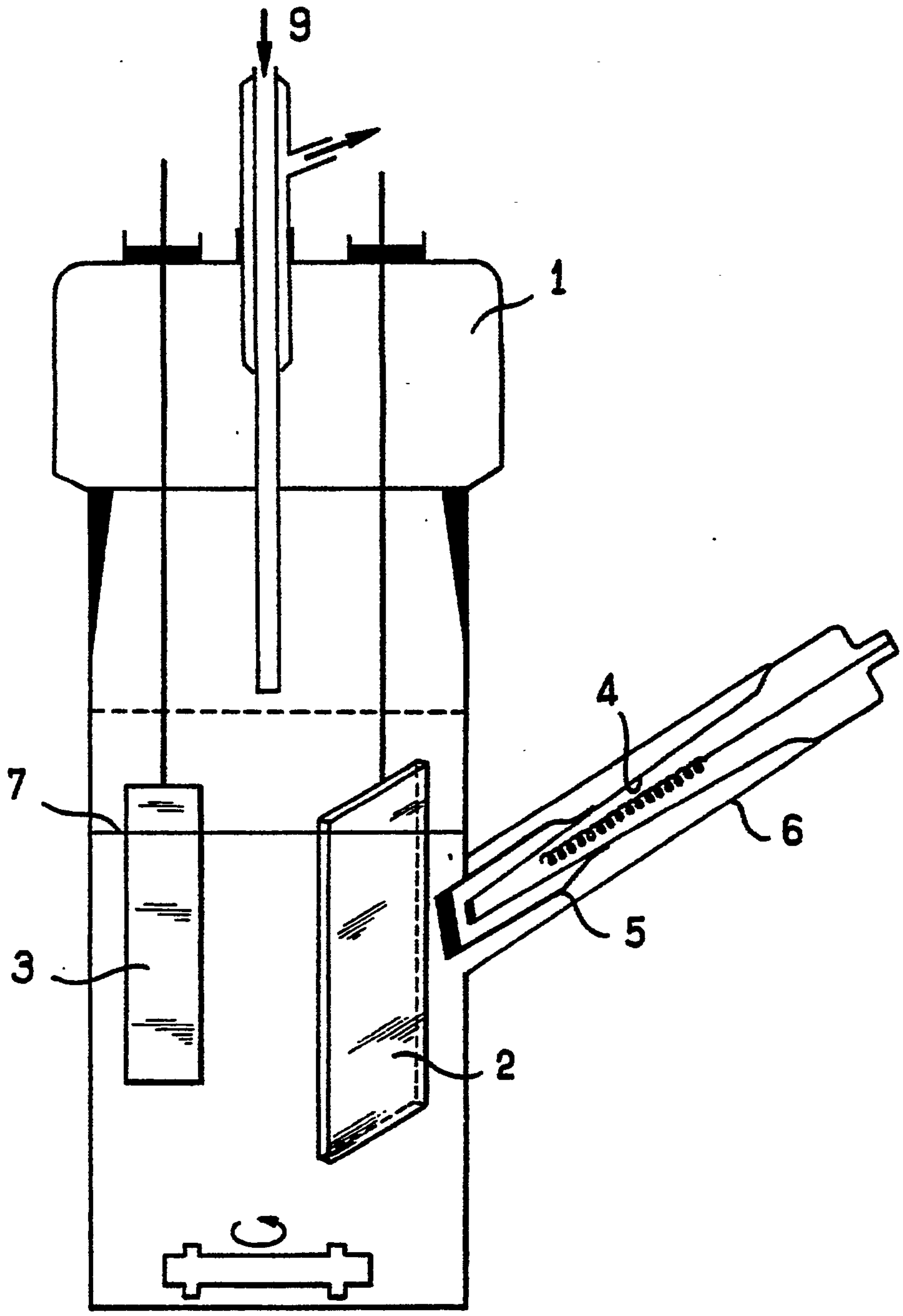


FIG.1

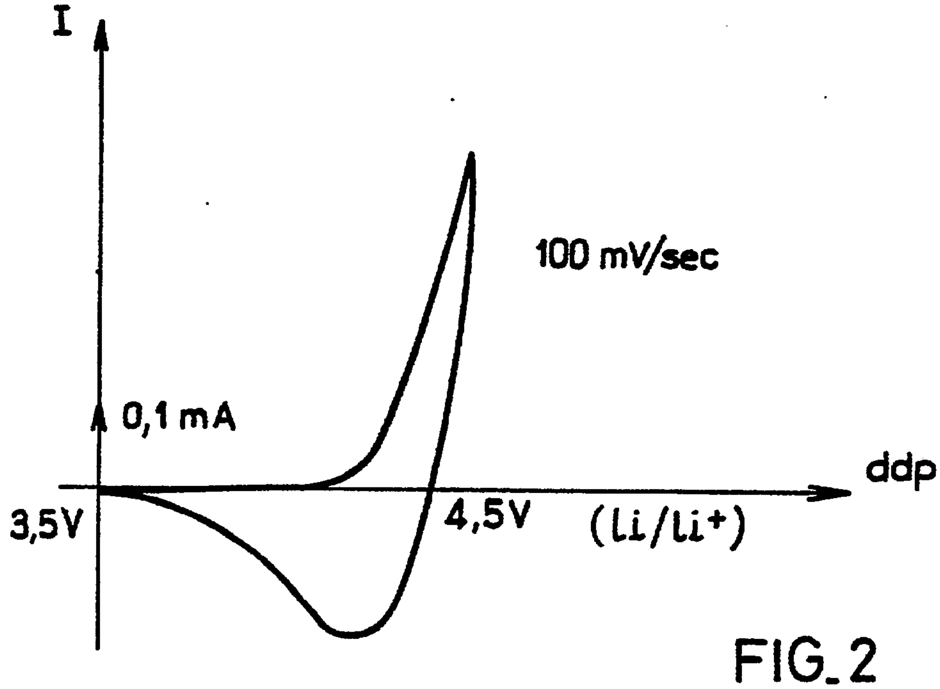


FIG_2

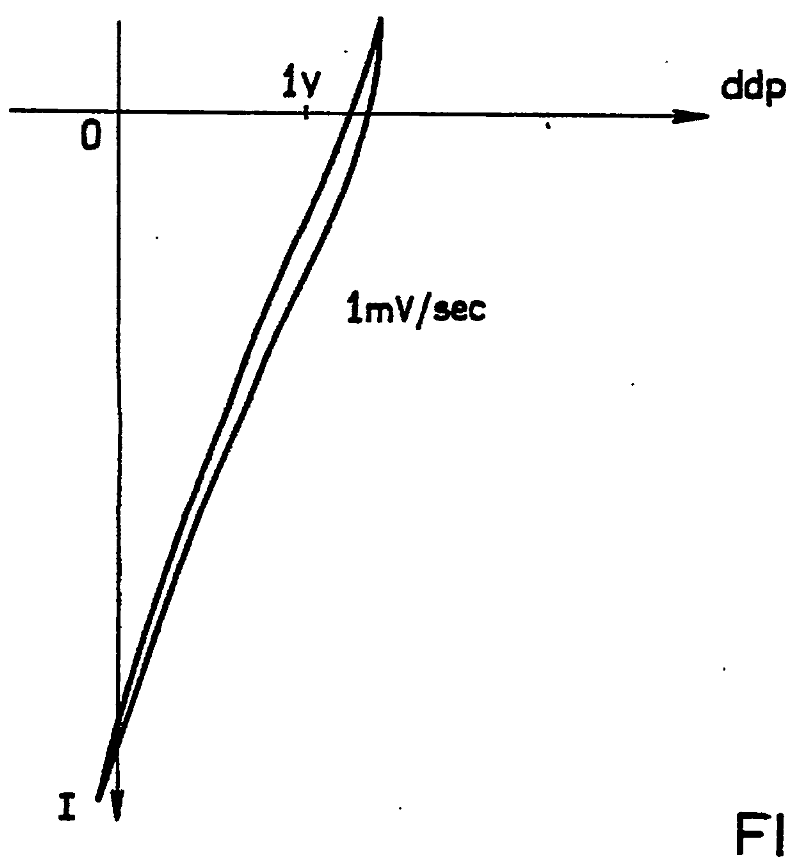


FIG_3